Europäisches Patentamt

European Patent Office

Office européen des brevets

(11) Publication number: 0 475 139 A2

# EUROPEAN PATENT APPLICATION

(21) Application number: 91114035.8

(22) Date of filing: 22.08.91

(51) Int. Cl.5: H03H 3/08

(30) Priority: 04.09.90 US 577181

(43) Date of publication of application:
18.03.92 Bulletin 92/12

(84) Designated Contracting States:
DE FR GB

(71) Applicant: MOTOROLA, INC.
1303 East Algonquin Road
Schaumburg, IL 60196(US)

(72) Inventor: Cho, Fred Yi-Tung
8731 E Monterey Way
Scottsdale, Arizona 85251(US)
Inventor: Penunuri, David
10422 N Demaret Drive
Fontain Hills, Arizona 85268(US)
Inventor: Falkner, Robert Frank Jr.
6625 E Kasba Circle
Paradise Valley, Arizona 85253(US)

(74) Representative: Lupton, Frederick et al
Motorola European Intellectual Property
Operations Seal House Seal Road
Basingstoke, Hants RG21 1NO(GB)

(54) Method and apparatus for SAW device passivation.

(57) A passivation layer (110) of dielectric material disposed on the top surface of the SAW device (10) prevents the metallized transducer pattern (30, 40) on the piezoelectric substrate (20) from being exposed to chemical attack. This layer (110) also provides for improved metal acousto-migration resistance through the well-known mechanism of grain boundary pinning. The piezoelectric SAW device substrate (20) includes a dielectric layer (110) which is disposed along the surface over the transducer (30, 40) metallization. The piezoelectric substrate (20) includes metallized regions (120) on top of the dielectric layer (110) which is disposed over the substrate (20) surface and the SAW transducers (30, 40) thereon. These metallized regions (120) form capacitors to the transducer busses (131, 136, 141, 146) and capacitively couple electrical input and output signals to the transducers (30, 40) from external electronic apparatus (90, 95).

FIG. 2

## Field of the Invention

This invention pertains to surface acoustic wave (SAW) devices and more particularly to an arrangement for improving SAW device corrosion resistance and reliability.

## Background of the Invention

A surface acoustic wave device includes a piezoelectric substrate which has a highly polished surface and metallized SAW transducer patterns on that surface. The transducers are disposed on the polished surface of the piezoelectric substrate such that they are acoustically coupled to one another. The transducer patterns consist of metal strips which couple electrical signals to acoustic signals through the piezoelectric effect, and summing busses which connect the strips to form a filter function and which act as the external electrical connections to the strips. The metal strips of the SAW device, if exposed to the environment directly, can become contaminated and corrode. Passivation of the SAW devices including metal strips has been attempted, but making an electrical connection to these metal strips is a problem since a hole, or via, must be cut through the passivation layer to make electrical connection to the metal strips. Holes in the passivation material allow the environment to attack and contaminate the metal strips. Prior art passivation techniques have relied on holes etched through the passivating layer in order to establish DC connection to the underlying circuitry. Contaminants can adversely affect the performance of these SAW devices by absorbing acoustic energy or by reacting chemically with the transducer metallization.

## Summary of the Invention

Therefore, it is an object of the present invention to provide an SAW device which is passivated against chemical attack and having less stringent manufacturing and packaging requirements.

In accomplishing the object of the present invention, a novel SAW device passivation technique which utilizes capacitive coupling of the input and output signals through the passivation layer is shown.

The passivation apparatus for coupling to a surface acoustic wave device includes a substrate which has an electrode structure. Also included is a SAW transducer. The SAW transducer is coupled to the substrate for producing surface acoustic waves.

The apparatus further includes a passivation layer which covers the substrate including the electrode structure and the SAW transducer for a predetermined thickness. Lastly, an AC coupling is provided. The AC coupling is disposed on the passivation layer and over the electrode structure. This provides for AC coupling of signals to the electrode structure of the SAW substrate.

The above and other objects, features, and advantages of the present invention will be better understood from the following detailed description taken in conjunction with the accompanying drawings.

## Brief Description of the Drawings

FIG. 1 is a plan view of a surface acoustic wave device.

FIG. 2 is a drawing of a cross section through a passivated SAW device.

## Description of the Preferred Embodiment

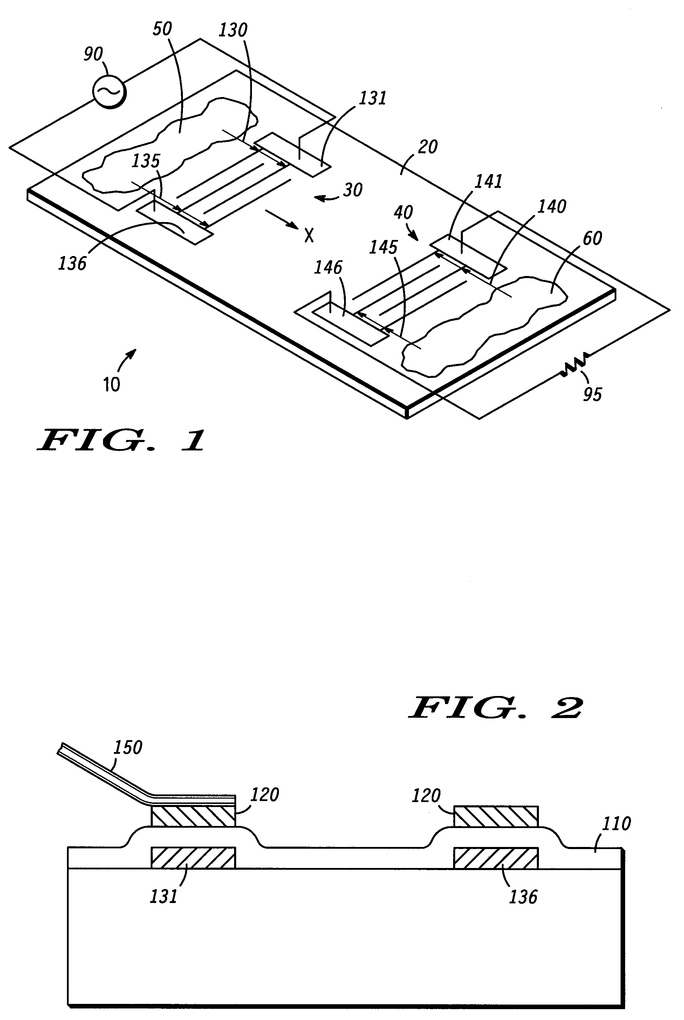

Referring to FIG. 1, a top view of a SAW device 10 which includes a piezoelectric substrate 20 and having interdigitated transducers 30 and 40 formed thereon is shown. Although two SAW transducers are shown, the present invention is not limited to configurations of only two SAW transducers. Piezoelectric substrate 20 may be implemented on a substrate such as one made of a piezoelectric semiconductor material. The piezoelectric substrate may comprise lithium niobate, lithium tantalate, quartz. The piezoelectric semiconductor substrate may comprise materials such as zinc oxide or aluminum nitride, as well as other suitable materials. The transducer 30 is composed of interdigitated combs of electrodes 130 and 135 together with bus bars 131 and 136 which serve to interconnect the electrode combs 130 and 135, respectively. The transducer 40 is composed of interdigitated combs of electrodes 140 and 145 and bus bars 141 and 146, which serve to interconnect the electrode combs 140 and 145, respectively. The electrodes 130, 135, 140, and 145, and the bus bars 131, 136, 141, and 146 may be formed of any suitable metal such as aluminum.

In normal use the transducer 30 will emit acoustic waves along the surface of the substrate 20 in direction X in response to electrical stimulation by an external voltage source 90 electrically coupled to bus bars 131 and 136. The substrate 20 acoustically couples the two transducers 30 and 40. The transducer 40 will emit an electrical signal from bus bars 141 and 146 in response to the acoustic wave launched from transducer 30, and couple this electrical signal to an external load 95.

The acoustic absorbers 50 and 60 are composed of a viscous material such as a room temperature vulcanizing silicone rubber and are placed to avoid unwanted reflections of acoustic signals from the edges of substrate 20, which, if not suppressed, would give rise to unwanted, spurious output signals. The interconnections to the external load 95 and source 90 are typically by means of wires, such as wire 150 of Fig. 2, bonded to the bus bars 131, 136, 141, and 146, but may be effected through other interconnection means as well.

FIG. 2 is a cross-sectional view of a SAW device 10 employing a dielectric passivation layer 110 disposed on the surfaces of substrate 20 and the SAW transducers 30 and 40. Dielectric passivation layer 110 may include a layer of hydrogenated silicon nitride. The hydrogenated silicon nitride layer may be deposited by plasma-enhanced chemical vapor deposition. SAW device 10 also includes upper metallized capacitor electrodes 120 which capacitively couple to the SAW transducer bus bars 131, 136, 141, and 146. External connections to other electronic circuitry are made via AC coupling to the upper capacitor electrodes 120 by either conventional wirebonding techniques, such as 150 shown, for example, or by other means.

The dielectric layer 110 thus completely covers all of the metallization of SAW transducers 30 and 40, in contrast to prior art. SAW devices operate at RF signals up to several gigahertz in frequency. Signals can be coupled in and out of the SAW transducers through the dielectric passivation layer 110 as shown in FIG. 2. The coupling capacitance, $C_c$, is approximated by:

$$C_c = \epsilon_r \epsilon_0 A/d$$

where $\epsilon_r$ is the relative dielectric constant of the passivation layer, $\epsilon_0$ is the permittivity of free space, A is the parallel plate area between the wire bond and the coupling pad, and d is the thickness of the passivation layer as shown in FIG. 2. The absence of etched vias in this approach ensures complete protection of SAW transducer metallization from chemical attack, scratching due to handling of the devices during fabrication, and contamination. Further, the capacitive coupling technique allows elimination of contact between the metals employed for SAW transducers and for external connections, which are often dissimilar. Contact between dissimilar metals is often the cause of metallurgical failure of such interconnects. The above described AC coupling by passivation may also be applied to semiconductor devices.

Although the preferred embodiment of the invention has been illustrated, and that form described in detail, it will be readily apparent to those skilled in the art that various modifications may be made therein without departing from the spirit of the invention or from the scope of the appended claims.

## Claims

1. Apparatus for passivation of a Surface Acoustic Wave (SAW) device (10) comprising:

    substrate means (20) including electrode means (131, 136, 141, 146);

    SAW transducer means (30, 40) coupled to said substrate means (20) for producing surface acoustic waves;

    passivation means (110) covering said SAW transducer means (30, 40) and said substrate means (20) to a predetermined thickness; and

    AC coupling means (120) disposed on said passivation means (110) and disposed over said electrode (131, 136, 141, 146) means of said SAW transducer means (34, 40) to provide for coupling of signals to said electrode means (131, 136, 141, 146).

2. Apparatus for passivation of a SAW (10) as claimed in claim 1, wherein said substrate means (20) includes piezoelectric means.

3. Apparatus for passivation of a SAW (10) as claimed in claim 1, wherein said electrode means (131, 136, 141, 146) includes metallized electrodes.

4. Apparatus for passivation of a SAW (10) as claimed in claim 1, wherein said passivation means (110) includes dielectric layer means.

5. Apparatus for passivation of a SAW (10) as claimed in claim 1, wherein said AC coupling means includes second electrode means (120).

6. Apparatus for passivation of a SAW (10) as claimed in claim 5, wherein said second electrode means (120) includes metallized electrodes.

7. Apparatus for passivation of a SAW device (10) as claimed in claim 1, wherein said particular thickness, d, of said passivation covering (110) may be approximated by:

$$d = \epsilon_r \epsilon_0 A/C_c$$

where $\epsilon_r$ is the relative dielectric constant of the passivation layer, $\epsilon_0$ is the permittivity of free space, A is the parallel plate area between the wire bond (150) and the coupling pad (120), and $C_c$ is the coupling capacitance.

8. A method for passivation of a Surface Acoustic Wave (SAW) device (10) comprising the steps of:
   providing a piezoelectric substrate (20) including first electrodes (131, 136, 141, 146); coupling a SAW transducer (30, 40) to the substrate (20); depositing a passivation layer (110) covering the substrate (20) and SAW transducer for a predetermined thickness; providing second electrodes (120) positioned on the passivation layer (110) and over the first electrodes (131, 136, 141, 146); and AC coupling electrical signals via the second electrode to the first electrode (131, 136, 141, 146).

9. A method for passivation of a SAW device (10) as claimed in claim 9, wherein the step of depositing a passivation layer (110) includes the step of depositing a passivation layer (110) to a particular thickness, d, approximated by:

$$d = \epsilon_r \epsilon_0 A / C_c$$

   where $\epsilon_r$ is the relative dielectric constant of the passivation layer, $\epsilon_0$ is the permittivity of free space, A is the parallel plate area between the wire bond (150) and the coupling pad (120), and $C_c$ is the coupling capacitance.

**FIG. 1**

**FIG. 2**